# EUROPÄISCHE PATENTSCHRIFT

(11) **EP 1 456 882 B1**
(45) Veröffentlichungstag und Bekanntmachung des Hinweises auf die Patenterteilung: **26.09.2012**
(21) Anmeldenummer: 02805285.0
(22) Anmeldetag: 21.11.2002
(51) Int. Cl.: H01L 23/66, H01L 23/29, H01L 23/552, H01L 25/07, H05K 1/02

(54) **SCHALTUNGSANORDNUNG MIT ELEKTRONISCHEN BAUELEMENTEN AUF EINEM ISOLIERENDEN TRÄGERSUBSTRAT**
CIRCUIT ARRANGEMENT COMPRISING ELECTRONIC COMPONENTS ON A NONCONDUCTING SUPPORTING SUBSTRATE
CIRCUIT COMPORTANT DES COMPOSANTS ELECTRONIQUES LOGES SUR UN SUBSTRAT SUPPORT ISOLANT

(30) Priorität: 20.12.2001 DE 10162637
(43) Veröffentlichungstag der Anmeldung: 15.09.2004
(73) Patentinhaber: Infineon Technologies AG, 85579 Neubiberg (DE)
(72) Erfinder: SCHILLING, Oliver, 59581 Warstein (DE)
(74) Vertreter: Schmuckermaier, Bernhard
(86) Internationale Anmeldenummer: PCT/EP2002/013098
(87) Internationale Veröffentlichungsnummer: WO 2003/054959

(56) Entgegenhaltungen:
- EP-A- 0 540 955
- EP-A- 0 575 889
- EP-A- 0 736 902
- EP-A- 0 785 557
- EP-A- 0 945 916
- DE-A- 10 006 505
- DE-A- 10 123 232
- JP-A- 10 229 291

## Beschreibung

Die Erfindung betrifft eine Schaltungsanordnung mit elektronischen Bauelementen auf einem isolierenden Trägersubstrat.

Halbleiterschalter mit einer Ansteuerung in MOS-Technik (=Metal Oxide Semiconductor) wie zum Beispiel IGBTs (=Insulated Gate Bipolar Transistors) oder MOSFETs (=Metal Oxide Semiconductor Field Effect Transistors) werden derzeit in Form von Halbleiterchips mit begrenzten Abmessungen von ca. 1-20mm Kantenlänge hergestellt. Zur Herstellung derartiger Schalter mit schaltbaren Strömen im Bereich über 1000 A ist es daher im allgemeinen erforderlich, mehrere Halbleiterchips parallel zu schalten und entsprechend in ein kompaktes Gehäuse - ein sogenanntes Modul bildend - zu montieren. Diese Vorgehensweise ist im Stand der Technik vielfältig beschrieben.

Ebenso ist es bekannt, dass die einzelnen Halbleiterschalter eine endliche Kapazität besitzen und die zur verdrahtung der einzelnen Halbleiterschalter verwendeten elektrischen Leiter (Leitbahnen, Bonddrähte, etc.) Streuinduktivitäten darstellen, die gemeinsam mit den o.g. Kapazitäten Schwingkreise bilden.

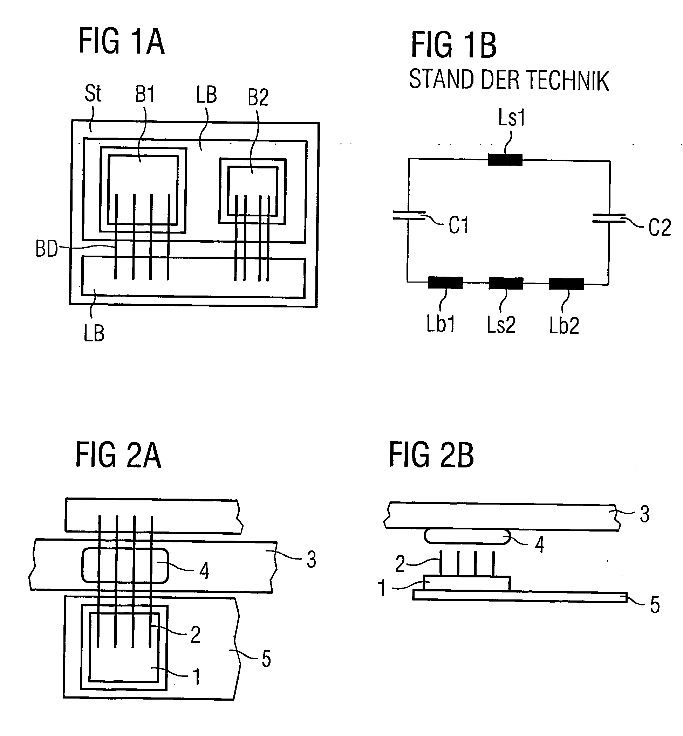

Eine einfache Parallelschaltung zweier Bauelemente B1, B2 ist in Fig. 1 gezeigt, wobei Fig. 1a die verallgemeinerte Darstellung einer Schaltungsanordnung aus zwei Bauelementen B1, B2 ist, die durch Leiterbahnen LB eines Substrates St und durch Bonddrähte BD miteinander elektrisch gekoppelt sind, und Fig. 1b das Ersatzschaltbild der Schaltungsanordnung aus Fig. 1a ist. In dem Ersatzschaltbild sind die für das Zustandekommen eines elektromagnetischen Schwingkreises relevanten Größen eingezeichnet (parasitäre Kapazitäten C1, C2 und Streuinduktivitäten der Substratleiterbahnen Ls1, Ls2 und der Bonddrähte Lb1, Lb2). Im allgemeinen ist auch eine magnetische Kopplung unter den Induktivitäten zu berücksichtigen, die durch die durchgezogene Linie unter Lb1, Ls2, Lb2 angedeutet ist.

Bei unzureichender ohmscher Bedämpfung der Schwingkreise kann es zu Resonanzen kommen, die im Betrieb beim Ein- bzw. Ausschalten der Halbleiterschalter angeregt werden und so erhebliche Störungen durch entstehende elektromagnetische Schwingungen verursachen. Verschiedene Abhilfemaßnahmen dazu wurden bereits im Stand der Technik diskutiert. Darunter fällt auch beispielsweise die in der DE 195 49 011 C2 beschriebene Methode, bei der die Streuinduktivität der zur Parallelschaltung benutzten Leiter mittels eines quer von Chip zu Chip geführten Bonddrahtes kurzgeschlossen wird. Allerdings ist diese Methode in vielen Fällen nicht ausreichend.

In der EP 0 785 557 A1 werden magnetische Substanzen beschrieben, die zur Unterdrückung elektromagnetischer Interferenzen auf einer Leiterplatte mit hochintegrierten Mikroprozessoren aufgebracht werden. Durch die Anordnung der Magnete auf der Leiterplatte wird die Bauelementdichte pro Flächeneinheit der Leiterplatte reduziert. Zusätzlich nimmt die nutzbare Fläche der Leiterplatte ab, weshalb die Anordnung der EP 0 785 557 A1 für leistungselektronische Anwendungen kaum geeignet ist.

Aufgabe der Erfindung ist es daher, eine Schaltungsanordnung der eingangs genannten Art anzugeben, bei der die Unterdrückung unerwünschter Resonanzen verbessert ist.

Die Aufgabe wird gelöst durch eine Schaltungsanordnung nach Anspruch 1. Ausgestaltungen und Weiterbildungen des Erfindungsgedankens sind Gegenstand von Unteransprüchen.

Bei der vorliegenden Erfindung wird zur Dämpfung und Verstimmung der Resonanzen vorgeschlagen, die Kopplung der im Falle von Resonanzen auftretenden magnetischen Wechselfelder mit der umgebenden Materie auszunutzen. Um eine solche Kopplung herzustellen, werden erfindungsgemäß magnetisierbare Substanzen in die nächste Umgebung der in den Resonanzkreisen vorkommenden Streuinduktivitäten und/oder parasitären Kapazitäten gebracht, da das zu dämpfende elektromagnetische Wechselfeld gerade von diesen Komponenten ausgeht.

Magnetisierbar sind prinzipiell alle Substanzen. Um eine effektive Kopplung mit dem elektromagnetischen Wechselfeld im Sinne der Erfindung hervorzurufen, ist es jedoch erforderlich, Materialien zu verwenden, die eine hohe magnetische Suszeptibilität besitzen. Dies ist vor allem bei ferro- und ferrimagnetischen Materialien aufgrund des kollektiven Magnetismus der in diesen Substanzen enthaltenen magnetischen Momente der Fall. Gelingt die magnetische Kopplung zwischen dem Wechselfeld und der magnetisierbaren Substanz, so kommt es in einem Wechselfeld, dessen Richtung sich permanent ändert, zu sogenannten Ummagnetisierungsverlusten bzw. Hystereseverlusten. Die hierfür aufgewandte Energie wird der Quelle des elektromagnetischen Wechselfeldes - also dem Schwingkreis - entzogen und dämpft so die Schwingung.

Bei der Auswahl des geeigneten magnetischen Materials ist zudem die Frequenzabhängigkeit der Suszeptibilität zu beachten. Die Schwingung, deren Resonanz gedämpft werden soll, liegt wegen der besonders niedrigen Beträge der parasitären Kapazitäten und Streuinduktivitäten (nH-Bereich) des Schwingkreises in einem äußerst hohen Frequenzbereich von typischerweise 10⁷-10⁹ Hz. Bei derartig hohen Frequenzen muss in magnetischen Materialien der Einfluss von Wirbelströmen berücksichtigt werden. Nach der Lenzschen Regel wirken die induzierten Wirbelströme dem äußeren Wechselfeld entgegen und verhindern so ein Eindringen des Feldes in das Material. Dadurch bedingt sinkt die magnetische Suszeptibilität mit zunehmender Frequenz in der Regel ab je nach Einfluss der Wirbelströme.

Zur Unterdrückung von Wirbelströmen werden zwei Alternativen bevorzugt: Zum einen kann leitfähiges magnetisierbares Material in Form von Schichten präpariert werden, die voneinander durch isolierende Lagen getrennt sind. Alternativ ist der Einsatz von oxidischen Magnetwerkstoffen (Ferrite) empfehlenswert. Wirbelströme spielen in Ferriten aufgrund ihres hohen spezifischen Widerstandes keine nennenswerte Rolle.

Im einzelnen wird die Aufgabe durch eine Schaltungsanordnung aus zwei oder mehr leistungselektronischen Bauelementen gelöst, die auf einem isolierenden Trägersubstrat angeordnet sind, wobei zur Dämpfung von unerwünschten elektromagnetischen Resonanzen, die unter den Bauelementen auftreten können, magnetische, insbesondere weichmagnetische Materialien in unmittelbarer Umgebung der Bauelemente angebracht werden. Die magnetischen Materialien sind von der elektrischen Schaltungsanordnung galvanisch getrennt und wirken nur über die Kopplung mit dem magnetischen Wechselfeld, das durch die Resonanzen hervorgerufen wird, auf die elektrische Schaltungsanordnung ein.

Als Bauelemente können IGBTs und/oder MOSFETs verwendet werden, die aufgrund der bei Schaltvorgängen vorkommenden hohen Strom- und Spannungssteilheiten dazu beitragen können, elektromagnetische Schwingvorgänge auszulösen.

Bevorzugt werden die Bauelemente mit dem Substrat durch Lötung verbunden.

Zur elektrischen Verbindung der Bauelemente untereinander und/oder anderen Elementen wie etwa externen Anschlüssen können auch Bonddrähte eingesetzt werden. Außerdem können zur elektrischen Verbindung auch z.B. metallische Stanzteile oder Kabelstücke und/oder Leiterbahnen auf dem isolierenden Trägersubstrat verwendet werden.

Das magnetische Material liegt in Pulverform oder in Form kleiner Partikel vor und ist mit einem Kunststoffrahmen einteilig verbunden, der spritztechnisch unter Verwendung einer Kunststoffmasse hergestellt ist, indem es gemeinsam mit der Kunststoffmasse in eine Form gespritzt wird, so dass auch eine komplexe geometrische Form erzeugt werden kann, die einerseits magnetische Eigenschaften besitzt und andererseits stabil und so geformt ist, dass sie über der Schaltungsanordnung
montiert werden kann. Damit wird die beabsichtige Wirkung der Schwingungsdämpfung an den entscheidenden Stellen erreicht. In einer nicht zur Erfindung gehorunden alternativen Ausführungsform kann das magnetische Material in Pulver- und/oder Körnerform auch einer Isoliermasse wie beispielsweise weichem Silikongel beigemischt werden und so die Bauelemente unmittelbar umgeben.

Es können magnetische Materialien mit geringer Tendenz zur Wirbelstrombildung eingesetzt werden, um einen dämpfenden Einfluss auch bei sehr hohen Frequenzen >100 MHz zu gewährleisten.

Als magnetisches Material kann dabei ein oxidischer Magnetwerkstoff mit hohem elektrischen Widerstand eingesetzt werden (z. B."Ferrite").

Die Erfindung wird nachfolgend anhand der in den Figuren der Zeichnung dargestelltem Ausführungsbeispiele näher erläutert.

Es zeigt:
- Figur 1: eine Schaltungsanordnung nach dem Stande der Technik in Draufsicht (a) und im Ersatzschaltbild (b),
- Figur 2: eine Ausführungsform einer Schaltungsanordnung mit einem auf ein Substrat aufgelöteten Halbleiterchip in Draufsicht (a) und in Seitenansicht (b),
- Figur 3: eine erste Ausführungsform einer Fixierung bei einer Schaltungsanordnung,
- Figur 4: eine zweite Ausführungsform einer Fixierung bei einer Schaltungsanordnung,
- Figur 5: eine dritte Ausführungsform einer Fixierung bei einer Schaltungsanordnung,
- Figur 6: eine erfindungsgemäße Ausführungsform einer Schaltungsanordnung,
- Figur 7: eine weitere Ausführungsform einer Schaltungsanordnung.

Die Ausführungsformen gemäß den Figuren 2 bis 5 und 7 sind nicht Gegenstand der vorliegenden Erfindung, sie dienen aber dazu, einzelne Aspekte der Erfindung näher zu erläutern.

Bei der in Figur 2 gezeigten Ausführungsform einer Schaltungsanordnung ist vorgesehen, das magnetische (und damit magnetisierbare) Material 4 in Form eines magnetischen Halbzeugs zu formen und in unmittelbarer Nähe eines der einen parasitären Schwingkreis bildenden Elemente zu positionieren, wobei das magnetische Material 4 unmittelbar über Bonddrähten 2 eines auf einem Substrat 5 aufgelöteten Halbleiter-Chips 1 positioniert ist. Um das magnetische Material 4 zu haltern, wird ein Rahmen 3 verwendet, der so geformt ist, dass das magnetische Material 4 an den geeigneten Stellen der Schaltungsanordnung positioniert werden kann. Der Rahmen 3 kann als Kunststoff-Spritzteil hergestellt werden, wodurch einerseits eine fast beliebige Formgebung erreicht wird und andererseits eine preisgünstige Herstellung ermöglicht wird.

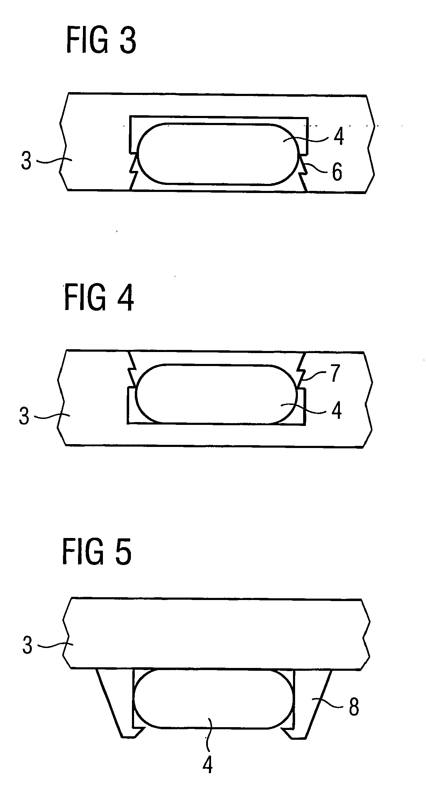

Um das magnetische Material 4 in dem Rahmen 3 zu fixieren, ist es in weiterbildung zweckmäßig, an geeigneten Stellen des Rahmens 3 Möglichkeiten zur Halterung des magnetischen Materials 4 vorzusehen. Einige bevorzugte Ausführungsformen derartiger Halterungen sind in den Figuren 3 bis 5 gezeigt.

Beispielsweise können gemäß den Figuren 3 und 4 geeignete Aussparungen in dem Rahmen 3 an der Innenseite zusätzlich mit einer unteren Verrippung 6 bzw. einer oberen Verrippung 7 versehen werden. Dies reicht in vielen Fällen aus, um das als Halbzeug ausgebildete magnetische Material 4 im Rahmen 3 zu fixieren.

Eine andere mechanische Fixiermöglichkeit ist gemäß Figur 5 beispielsweise durch eine entsprechende Rasthaken aufweisende Einschnappvorrichtung 8 gegeben, die einteilig mit dem Rahmen 3 verbunden ist.

Rein mechanische Fixierungen der oben geschilderten Art stellen eine sehr kostengünstige Lösung dar. Ein Einbau der magnetischen Halbzeugteile kann dabei automatisiert und schnell erfolgen. Die Vorrichtungen, die dafür an dem Rahmen notwendig sind, können einteilig mit demselben verbunden oder einstückig angeformt sein und sind somit kostengünstig durch eine geringfügige Modifikation der Spritzform serienmäßig herstellbar.

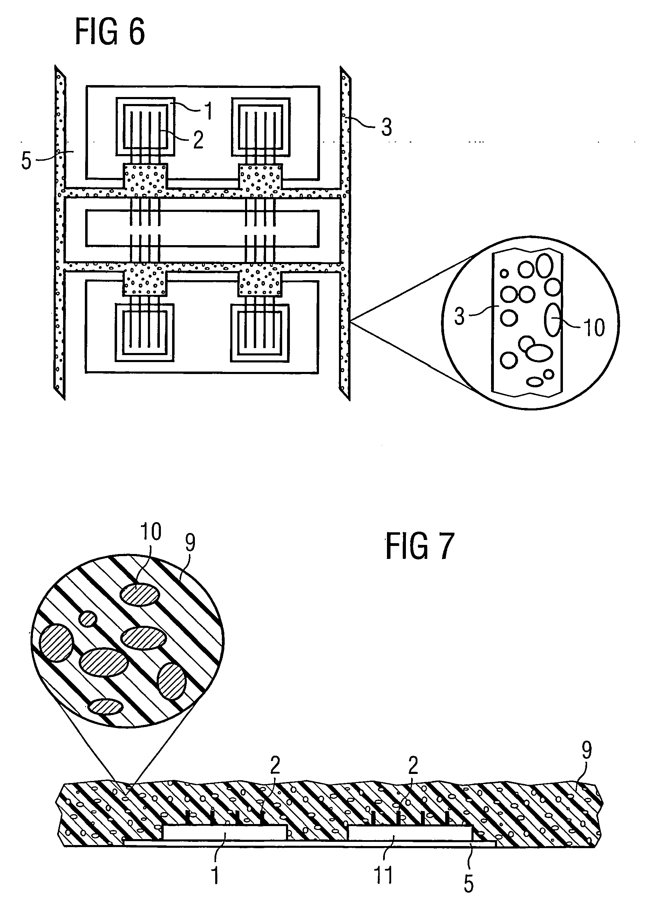

Weiterbildend ist in Figur 6 eine weitere, die Erfindung darstellende, noch rationeller herstellbare Ausführungsform einer erfindungsgemäßen Schaltungsanordnung gezeigt. Da das magnetische Material auch in Pulverform oder in Form kleiner Partikel 10 verfügbar ist, kann es einteilig mit dem Kunststoffrahmen 3 verbunden werden, indem es der Kunststoffmasse während des Abspritzens des Rahmens 3 beigemischt wird. Dadurch entsteht ein Hybrid aus Kunststoff und magnetisierbarem Material, der sowohl die Vorteile des Kunststoffes (leichte kostengünstige Formbarkeit) als auch die Funktion des magnetisierbaren Materials (Dämpfung der Resonanzen an den dafür entscheidenden Positionen) in sich vereint. Um die gesamte Induktivität der Schaltungsanordnung nicht unnötig zu erhöhen, was im allgemeinen vermieden werden soll, ist es empfehlenswert, den Hybrid-Kunststoffrahmen (Rahmen 3) möglichst dünnwandig zu gestalten und nur an den Stellen zu verstärken, an denen eine Dämpfung beabsichtigt ist, also beispielsweise unmittelbar über den Bonddrähten 2 des Halbleiter-Chips 1 sowie ggf. weiterer (Halbleiter-) Bauelemente 11.

Das magnetisierbare Material in Pulverform oder in Form kleiner Partikel 10 kann gemäß Figur 7 auch einer Vergussmasse 9 beigemischt werden, die den Halbleiter-Chip 1 sowie ggf. weiterer Bauelemente 11 umgibt, um sie zu passivieren und elektrisch isolieren. Es handelt sich dabei um eine Schaltungsanordnung mit mehreren Bauelementen 1, 11, die über Bonddrähte 2 verbunden sind und die auf dem Substrat 5 montiert sind. Zur Dämpfung von elektromagnetischen Resonanzen wird in die ansonsten als Isolierstoff dienende weiche Vergussmasse 9 (z.B. Silikongel) ein magnetisches Material in Form von magnetischen Partikeln 10 gemischt.

Sämtliche gezeigten Ausführungsbeispiele haben gemeinsam, dass mindestens eines der Bauelemente 1, 11 ein IGBT und/oder MOSFET ist. Zur elektrischen Verbindung der Bauelemente 1, 11 untereinander und/oder mit externen Anschlüssen sind auf dem Substrat 5 (in den Figuren 2 bis 7 nicht näher dargestellte) Leiterbahnen aufgebracht. Die Bauelemente 1, 11 sind dabei mit dem elektrisch isolierenden Substrat 5 bzw. den darauf befindlichen Leiterbahnen durch Lötung verbunden und bilden ein sogenanntes Leistungshalbleitermodul.

Das bei den Ausführungsbeispielen verwendete magnetische Material 4 weist eine geringe Tendenz zur Wirbelstrombildung und einen hohen elektrischen Widerstand (oxidischer Magnetwirkstoff) auf.

Anstelle von Bonddrähten können zur elektrischen Verbindung der Bauelemente 1, 11 untereinander und/oder mit externen Anschlüssen zusätzlich oder alternativ metallische Stanzteile oder Leiterstücke vorgesehen sind.

### Bezugszeichenliste:

- 1: Halbleiter-Chip
- 2: Bonddrähte
- 3: Rahmen
- 4: Magnetisches Material
- 5: Substrat
- 6: Verrippung
- 7: Verrippung
- 8: Einschnappvorrichtung
- 9: Vergussmasse
- 10: Magnetische Partikel
- 11: Bauelement(e)
- C1, C2: Streukapazität
- Ls1, Ls2: Streuinduktivität
- Lb1, Lb2: Streuinduktivität
- BD: Bonddraht
- St: Substrat
- B1, B2: Bauelement
- LB: Leiterbahn

## Patentansprüche

1. Schaltungsanordnung mit elektronischen Bauelementen (1, 11) auf einem isolierenden Trägersubstrat (5), bei der weichmagnetische Materialien (4, 10) in Pulverform oder in Form kleiner Partikel in unmittelbarer Umgebung der Zuleitungen der Bauelemente (1, 11) an den Stellen der Schaltungsanordnung, an denen Streuinduktivitäten und/oder parasitäre Kapazitäten vorkommen, angeordnet sind, wobei die weichmagnetischen Materialien (4, 10) von der elektrischen schaltungsanordnung galvanisch getrennt, jedoch mit dieser magnetisch gekoppelt sind derart, dass an den Bauelementen (1, 11) auftretende elektromagnetische Resonanzen gedämpft werden,
**dadurch gekennzeichnet, dass**
das weichmagnetische Material (4, 10) mit einem Kunststoffrahmen (3), der spritztechnisch unter Verwendung einer Kunststoffmasse hergestellt ist, der das weichmagnetische Material (4, 10) beigemischt ist, einteilig verbunden ist.

2. Schaltungsanordnung nach Anspruch 1, bei der mindestens eines der Bauelemente (1, 11) ein IGBT und/oder MOSFET ist.

3. Schaltungsanordnung nach Anspruch 1 oder 2, bei der die Bauelemente (1, 11) mit dem Trägersubstrat (5) durch Lötung verbunden sind.

4. Schaltungsanordnung nach einem der vorherigen Ansprüche, bei der zur elektrischen Verbindung der Bauelemente (1, 11) untereinander und/oder mit externen Anschlüssen Bonddrähte (2) vorgesehen sind.

5. Schaltungsanordnung nach einem der vorherigen Ansprüche, bei der zur elektrischen Verbindung der Bauelemente (1, 11) untereinander und/oder mit externen Anschlüssen metallische Stanzteile vorgesehen sind.

6. schaltungsanordnung nach einem der vorherigen Ansprüche, bei der zur elektrischen Verbindung der Bauelemente (1, 11) untereinander und/oder mit externen Anschlüssen auf dem isolierenden Trägersubstrat (5) aufgebrachte Leiterbahnen vorgesehen sind.

7. Schaltungsanordnung nach einem der vorherigen Ansprüche, bei der das weichmagnetische Material (4, 10) einen hohen elektrischen Widerstand aufweist.

8. Schaltungsanordnung nach Anspruch 7, bei der als weichmagnetisches Material (4, 10) mit einem hohen elektrischen Widerstand ein oxidischer Magnetwirkstoff vorgesehen ist.

## Claims

1. Circuit arrangement comprising electronic components (1, 11) on an insulating carrier substrate (5), wherein soft-magnetic materials (4, 10) in powder form or in the form of small particles are arranged in direct proximity to the leads of the components (1, 11) at the locations of the circuit arrangement at which leakage inductances and/or parasitic capacitances occur, wherein the soft-magnetic materials (4, 10) are electrically isolated from the electrical circuit arrangement, but are magnetically coupled thereto in such a way that electromagnetic resonances occurring at the components (1, 11) are damped,
**characterized in that**
the soft-magnetic material (4, 10) is integrally connected to a plastics frame (3) produced by injection moulding using a plastics compound with which the soft-magnetic material (4, 10) is admixed.

2. Circuit arrangement according to Claim 1, wherein at least one of the components (1, 11) is an IGBT and/or MOSFET.

3. Circuit arrangement according to Claim 1 or 2, wherein the components (1, 11) are connected to the carrier substrate (5) by soldering.

4. Circuit arrangement according to any of the preceding claims, wherein bonding wires (2) are provided for electrically connecting the components (1, 11) among one another and/or to external terminals.

5. Circuit arrangement according to any of the preceding claims, wherein metallic stamped parts are provided for electrically connecting the components (1, 11) among one another and/or to external terminals.

6. Circuit arrangement according to any of the preceding claims, wherein conductor tracks applied on the insulating carrier substrate (5) are provided for electrically connecting the components (1, 11) among one another and/or to external terminals.

7. Circuit arrangement according to any of the preceding claims, wherein the soft-magnetic material (4, 10) has a high electrical resistance.

8. Circuit arrangement according to Claim 7, wherein an oxidic magnetic active substance is provided as soft-magnetic material (4, 10) having a high electrical resistance.

## Revendications

1. Circuit qui comporte des composants électroniques (1, 11) sur un substrat (5) support isolant et dans lequel des matériaux (4, 10) magnétiques doux sous forme pulvérulente ou sous forme de petites particules sont disposées à proximité immédiate des lignes d'alimentation des composants (1, 11) aux points du circuit auxquels se produisent des inductances de suite et des capacités parasitaires, les matériaux (4, 10) magnétiques doux étant séparés galvaniquement du circuit électrique, en étant cependant couplés à ce dernier de manière magnétique de sorte que des résonances électromagnétiques se produisant sur les composants (1, 11) soit amorties, **caractérisé en ce que** le matériau (4, 10) magnétique doux est lié en une seule pièce à un cadre (3) plastique qui est fabriqué suivant la technique de moulage par injection par utilisation d'une masse de matière plastique, qui est mélangée au matériau (4, 10) magnétique doux.

2. Circuit suivant la revendication 1, dans lequel au moins l'un des composants (1, 11) est un circuit IGBT et/ou MOSFET.

3. Circuit suivant la revendication 1 ou 2, dans lequel les composants (1, 11) sont reliés au substrat (5) support par brasure.

4. Circuit suivant l'une des revendications précédentes, dans lequel sont prévus, pour la liaison électrique des composants (1, 11) les uns avec les autres et/ou avec des raccords externes, des fils de liaison.

5. Circuit suivant l'une des revendications précédentes, dans lequel, pour la liaison électrique des composants (1, 11) les uns avec les autres et/ou avec des raccords externes, sont prévues des pièces découpées métalliques.

6. Circuit suivant l'une des revendications précédentes, dans lequel, pour la liaison électrique des composants (1, 11) les uns avec les autres et/ou avec des raccords externes, sont prévues des pistes conductrices disposées sur le substrat (5) de support isolant.

7. Circuit suivant l'une des revendications précédentes, dans lequel le matériau (4, 10) magnétique doux a une résistance électrique élevée.

8. Circuit suivant la revendication 7, dans lequel en tant que matériau (4, 10) magnétique doux ayant une résistance électrique élevée il est prévu une substance magnétique obtenue par voie d'oxydation.
